# EUROPEAN PATENT SPECIFICATION

(11) **EP 1 791 187 B1**
(45) Date of publication and mention of the grant of the patent: **26.08.2009**
(21) Application number: 05111472.6
(22) Date of filing: 29.11.2005
(51) Int. Cl.: H01L 33/00, H01S 5/024

(54) **Light emitting device**
Licht aussendendes Bauelement
Dispositif émetteur de lumière

(43) Date of publication of application: 30.05.2007
(73) Proprietor: National Central University, Jungli City, 320 Taoyuan (TW)
(72) Inventor: Chen, Jyh-Chen, 320, Jungli City, Taoyuan, (TW); Chou, Han-Yuan, 320, Jungli City, Taoyuan, (TW); Sheu, Gwo-Jiun, 320, Jungli City, Taoyuan, (TW); Hwu, Farn-Shiun, 320, Jungli City, Taoyuan, (TW); Cheng, Chine-Hung, 320, Jungli City, Taoyuan, (TW)
(74) Representative: Reichert, Werner Franz

(56) References cited:
- WO-A-20/05008790
- DE-A1- 10 102 353
- US-A- 5 309 457
- US-A- 6 107 645
- US-A1- 2003 183 269
- US-A1- 2004 222 516
- US-B1- 6 498 355
- US-B1- 6 724 791

## Description

The present invention relates to a light emitting device, and particularly to a light emitting device having an enhanced heat dissipation ability and being economic in power consumption.

Having the advantages of high illuminance, rapid response, small bulk, less contamination, high reliability and mass-production, light emitting diodes (LEDs) are becoming more and more widely used in illumination field and consumer electronic product development. LEDs are now used in large bulletin boards, traffic signal lights, cell phones, scanners, light sources for facsimile machines and illumination devices. Therefore, researches and developments of LEDs having high light emitting efficiency and high luminance are highly demanded.

The German Patent Application DE 101 02 343 discloses a LED-device which has encapsulated LED-modules. The module has circuit plate and an optic plate. The driving circuit is arranged externally.
The U.S. Patent 6,498,355 discloses a light emitting diode array in accordance with the present invention includes a metal substrate, a dielectric layer disposed above the metal substrate, and a plurality of electrically conductive traces disposed on the dielectric layer. The light emitting diode array also includes a plurality of light emitting diodes, each of which is disposed above a corresponding one of said vias and each of which includes a first electrical contact and a second electrical contact electrically coupled to separate ones of the electrically conductive traces. Each of the vias contains a thermally conductive material in thermal contact with the metal substrate and in thermal contact with the corresponding light emitting diode.
The U.S. Patent 5,309,457 discloses a diode laser array made from a plurality of linear laser diode array assemblies affixed and in good thermal communication with bodies containing micro-heat pipes. Assemblies are stacked in a vertical manner to form two dimensional arrays. Each assembly is connected electrically and mechanically to adjacent assemblies to form the final assembly.
The U.S. Patent Application 2003/0183269 discloses an apparatus having a cooling device capable of both power generation using heat from a heat-generating component and cooling of the heat-generating component is provided. The cooling device has a heat-receiving part which receives heat conducted from a CPU, which is an external heat-generating component, a thermoelectric conversion part arranged to absorb heat from the heat-receiving part and having operating modes including a mode of cooling the heat-receiving part by being supplied with a current and a power generation mode of converting heat received from the heat-receiving part into a current and outputting the current, and a selecting part which makes a selection according to a temperature condition of the CPU as to in which one of the modes the thermoelectric conversion part should be operated.

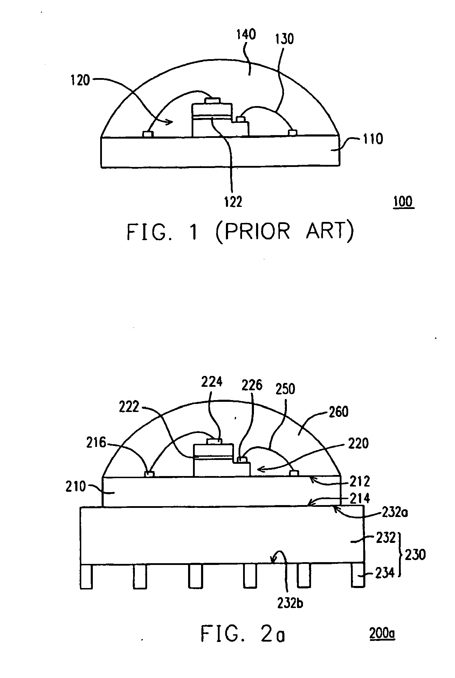

Referring to FIG. 1, a schematic view of a conventional light emitting device is illustrated. The light emitting device 100 comprises a substrate 110, a light emitting chip 120, a plurality of conducting wires 130 and an encapsulation 140. The light emitting chip 120 is disposed on the substrate 110 and is electrically connected with the substrate 110 via the conducting wires 130. The encapsulation 140 is disposed on the substrate 110 for covering the light emitting chip 120.

After a long time operation, or operating under poor heat dissipation condition, the temperature of the conventional light emitting chip 120 will increase. Therefore, an internal quantum efficiency of a light emitting layer 122 and the luminous efficiency of the light emitting chip 120 will decrease accordingly. However, in order to sustain the luminance of the light emitting chip 120, the input power has to be increased
accordingly which will adversely generate more heat needed to dissipate. Consequently, the temperature of the light emitting chip 120 will rise even higher resulting in a decrease of the luminance, emitting efficiency and lifetime.

Therefore, an object of the present invention is to provide a light emitting device having enhanced heat dissipation ability and to provide a light emitting device adapted for power recycling and thus reducing power consumption.

According to the above and other objects, the present invention proposes a light emitting device according to appended claim 1. Preferred embodiments are set out in the dependent claims.

The present invention provides a light emitting device which includes a substrate, at least one light emitting chip, a thermoelectric converter and a first heat dissipating element. The substrate has a top surface, on which a plurality of contacts are disposed, and a bottom surface. The light emitting chip is disposed on the top surface of the substrate, being in contact with the contacts. The light emitting chip includes a light emitting layer, a positive electrode and a negative electrode. The light emitting layer can be excited to emit a light by a current applied between the positive electrode and the negative electrode. The thermoelectric converter is disposed at the bottom surface of the substrate, and is adapted for absorbing heat generated by the light emitting chip and transferring the heat into electric power. The electric power is then outputted to the light emitting chip via the substrate electrode. The first heat dissipating element is disposed at a bottom surface of the thermoelectric converter.

According to an embodiment of the light emitting device, the substrate, for example, can be a printed circuit board or a silicon-based substrate. The substrate, for example, is composed of a plurality of circuit layers and at least one dielectric layer which are alternately stacked to each other. The foregoing contacts are at the topmost circuit layer.

According to an embodiment of the light emitting device, the light emitting chip, for example, is a red light LED chip, a green light LED chip or a blue light LED chip. In an embodiment, the light emitting chip is, for example, is an LED chip composed of a red light LED chip, a green light LED chip and a blue light LED chip.

According to an embodiment of the light emitting device, the first heat dissipation element, for example, includes a metal panel. The metal panel, for example, has a first surface and a second surface. The first surface of the metal panel is in contact with the bottom surface of the thermoelectric converter. In an embodiment, the first heat dissipation element, for example, further includes a plurality of fins disposed at the second surface of the metal panel. The metal panel, for example, is made of silver, copper or aluminum. The foregoing fins, for example, are made of silver, copper or aluminum.

According to an embodiment of the present invention, the light emitting device, for example, includes a second heat dissipation element disposed between the bottom surface of the thermoelectric converter and the first heat dissipation element. The second heat dissipation, for example, is composed of micro-heat-pipes or micro channels.

According to an embodiment of the invention, the light emitting device, for example, further includes a plurality of conducting wires and an encapsulation. The positive electrode and the negative electrode of the light emitting chip are connected to the contacts of the substrate via the conducting wires. In an embodiment, the light emitting chip, for example, further includes a plurality of bumps, by which the positive electrode and the negative electrode of the light emitting chip are connected to the contacts of the substrate.

According to an embodiment of the invention, the thermoelectric converter, for example, is made of bismuth telluride, lead telluride or silicon germanium alloy.

In summary, the light emitting device according to the present invention employs a first heat dissipation element for evacuating the heat generated by the light emitting chip out of the light emitting device to sustain the light emitting chip at a lower operation temperature and to improve a light emitting efficiency of the light emitting layer. The light emitting device can further include a thermoelectric converter disposed at the bottom surface of the substrate. The thermoelectric converter is adapted for absorbing heat from the light emitting chip and converting the heat into electric power. The electric power is then outputted to the light emitting chip via the contacts of the substrate. Hence, the light emitting device can recycle the power consumed and eliminate the loss of the power evacuated.

The features of the invention which are believed to be novel are set forth with particularity in the appended claims. The invention, together with its objects and the advantages thereof, may be best understood by reference to the following description taken in conjunction with the accompanying drawings, in which like reference numerals identify like elements in the figures and in which:

FIG. 1 is a schematic view of a conventional light emitting device.

FIG. 2a is a schematic view of a light emitting device of a wire bonding type according to a first illustrative example.

FIG. 2b is a schematic view of another light emitting device of a wire bonding type according to the first illustrative example.

FIG 3 is a schematic view of a light emitting device of a wafer bonding type according to a second illustrative example.

FIG. 4 is a schematic view of a light emitting device of a flip chip bonding type according to a third illustrative example.

FIG. 5a is a schematic view of a light emitting device (of a wire bonding type) having a thermoelectric converter according to the invention.

FIG. 5b is a schematic view of another light emitting device (of a wire bonding type) having a thermoelectric converter according to the invention.

### The First Illustrative Example

Referring to FIG 2a, a light emitting device (wire bonding type) according to a first example not forming part of the invention is illustrated. The light emitting device 200a includes a substrate 210, at least a light emitting chip 220 and a first heat dissipation element 230. The substrate 210 has a top surface 212, on which a plurality of contacts 216 are disposed, and a bottom surface 214. In the present example, the substrate 210, for example, can be a printed circuit board or a circuit board comprising a plurality of circuit layers and at least one dielectric layer which are alternately stacked to each other. The contacts 216 are disposed at the topmost circuit layer (not shown) of the substrate 210.

The foregoing light emitting chip 220, being in contact with the contacts 216, is disposed on the top surface 212 of the substrate 210. The light emitting chip 220 includes a light emitting layer 222, a positive electrode 224 and a negative electrode 226. The light emitting layer 222 can be excited to emit a light by a current applied between the positive electrode 224 and the negative electrode 226. In the example, the light emitting chip 220, for example, is a red light LED chip, a green light LED chip or a blue light LED chip. The light emitting chip also may be an LED chip composed of a red light LED chip, a green light LED chip and a blue light LED chip or any two of such.

The light emitting device 200a, for example, further includes a plurality of conducting wires 250 and an encapsulation 260. The positive electrode 224 and the negative electrode 226 of the light emitting chip 220 are connected to the contacts 216 of the substrate 210 via the conducting wires 250. The conducting wires 250 are made of silver, copper or other electrically conductive materials. Furthermore, the encapsulation 260 is disposed on the substrate 210 for covering the light emitting chip 220 and the conducting wires 250.

It is to be noted that, in order to lower the operation temperature of the light emitting chip 220, the light emitting device 200a further includes a heat dissipation element 230. The heat dissipation element 230 is disposed at the bottom surface 214 of the substrate 210. The heat dissipation element 230, for example, includes a metal panel 232. The metal panel 232, for example, has a first surface 232a and a second surface 232b. The first surface 232a of the metal panel 232 is in contact with the bottom surface 214 of the substrate 210. In the example, the first heat dissipation element 230, for example, further includes a plurality of fins 234 disposed at the second surface 232b of the metal panel 232. To obtain better heat dissipating effect, the metal panel 232, for example, is made of silver, copper or aluminum. The foregoing fins 234 on the second surface 232b of the metal panel 232, for example, are also made of silver, copper or aluminum.

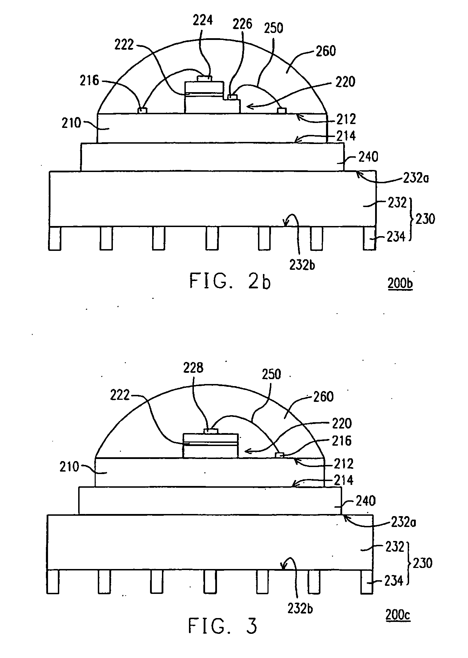

Referring to FIG. 2b, another light emitting device (wire bonding type) according to the first example is illustrated. In order to have the heat generated by the light emitting chip 220 evacuated promptly, the light emitting device 200b further includes a second heat dissipation element 240 disposed between the bottom surface 214 of the substrate 210 and the first heat dissipation element 230. In the example, the second heat dissipation element 240, for example, is composed of micro heat pipes or micro channels. The micro heat pipes or the micro channels of the second heat dissipation element 240 can be disposed in the form of parallel lines or radial lines. In order to improve the thermal conductivity, the micro heat pipes or micro channels may employ a single phase flow (vapor phase or liquid phase) or a double phase flow (vapor phase and liquid phase). In this example, the second heat dissipation element 240, for example, is made of copper, aluminum, silver or silicon. It is to be noted that according to another aspect of the example, the foregoing second heat dissipation element 240 can also be disposed in the substrate 210. In addition, the second heat dissipation element 240 in the substrate 210 is in contact with the first heat dissipation element 230.

In operation, the heat generated by the light emitting chip 220 of the light emitting device 200b is first conducted to the substrate 210 under the light emitting chip 220. The substrate 210 transfers the absorbed heat in sequence to the second heat dissipation element 240 and the first heat dissipation element 230 for evacuating the heat generated by the light emitting chip 220 out of the light emitting device 200b, and thus lowering the operating temperature of the light emitting chip 220. Therefore, the light emitting efficiency of the light emitting layer 222 can be improved. It is to be noted that the first heat dissipation element 230 and the second heat dissipation element 240 are not limited to be applied in a light emitting chip 220 of a wire bonding type; they can also be applied in light emitting chips of a wafer bonding type of the second example or a flip chip bonding type of the third example.

### The Second Illustrative Example

Referring to FIG. 3, a light emitting device of a wafer bonding type according to a second illustrative example not forming part of the invention is illustrated. It is to be noted that the heat dissipation elements provided in the second example are similar or equivalent in structure to the heat dissipation elements provided in the first example. Therefore, the structure of the heat dissipation element of the second example will not be described again, and references of the heat dissipation elements of the first example will continue to be used in the second example.

A light emitting device 200c includes a substrate 210, at least a light emitting chip 220, a first heat dissipation element 230, a second heat dissipation element 240, at least a conducting wire 250 and an encapsulation 260. The substrate 210 has a top surface 212, on which at least a contact 216 is disposed, and a bottom surface 214. In this example, the substrate 210, for example, can be a silicon substrate. The light emitting chip 220, being in contact with the contact 216, is disposed on the top surface 212 of the substrate 210. The light emitting chip 220 includes a light emitting layer 222 and an electrode 228. The light emitting layer 222 can be excited to emit a light by a current applied on the electrode 228. Moreover, the electrode 228 of the light emitting chip 220 is connected to the contact 216 of the substrate 210 via the conducting wires 250. The encapsulation 260 is disposed on the substrate 210 for covering the light emitting chip 220 and the conducting wires 250.

In operation, the heat dissipation structure (the heat dissipation elements 230 and 240) evacuates the heat generated by the light emitting chip 220 of the light emitting device 200c, and thus lowering the operating temperature of the light emitting chip 220. Therefore, the light emitting efficiency of the light emitting layer 222 can be improved.

### The First Embodiment

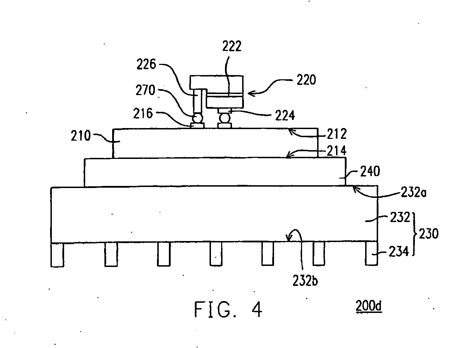

Referring to FIG. 4, a light emitting device of a flip chip bonding type according to a third embodiment example not forming part of the invention is illustrated. The structure of the light emitting device of the third example is substantially similar to that of the first example, thus only the differences therebetween are described herein. In the third example, a light emitting device 200d, for example, further includes a plurality of bumps 270, by which the positive electrode 224 and the negative electrode 226 of the light emitting chip 220 are connected to the contacts 216 of the substrate 210.

In operation, the heat generated by the light emitting chip 220 of the light emitting device 200b is first conducted to the substrate 210 under the light emitting chip 220 via the bumps 270. The substrate 210 transfers the absorbed heat in sequence to the second heat dissipation element 240 and the first heat dissipation element 230 for evacuating the heat generated by the light emitting chip 220 out of the light emitting device 200d, and thus lowering the operating temperature of the light emitting chip 220. Therefore, the light emitting efficiency of the light emitting layer 222 can be improved.

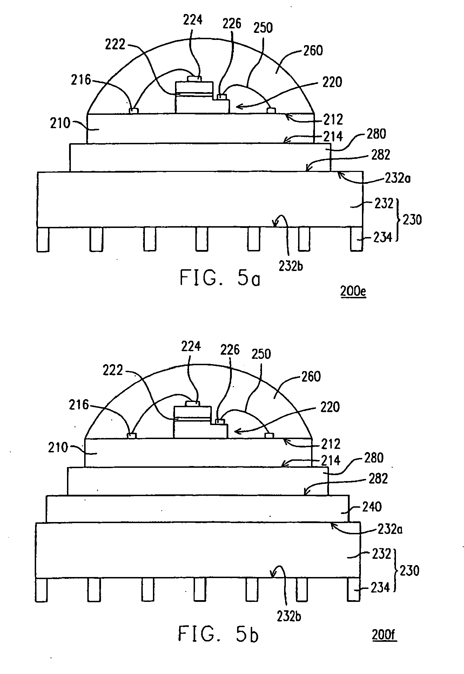

According to the above, light emitting chips will generate heat in operation. In order to recycle the heat generated by the light emitting chips, a light emitting device according to the present invention employs an element adapted for converting thermal power into electric power. Referring to FIG. 5a, a light emitting device of a wire bonding type is illustrated. The light emitting device 220 includes a thermoelectric converter 280. It is to be noted that the thermoelectric converter 280 is not limited to be applied in a light emitting chip 220 of a wire bonding type; it can also be applied in light emitting chips of a wafer bonding type and a flip chip bonding type. In the present invention, the emitting chip 220 of wire bonding type is used for illustration.

It is to be noted that the first embodiment is similar with the first example in structure and only the general difference therebetween will be described herein. The light emitting device 200e includes a substrate 210, at least one light emitting chip 220, a thermoelectric converter 280 and a first heat dissipating element 230. The thermoelectric converter 280 is disposed between the bottom surface 214 of the substrate 210 and the first heat dissipation element 230, and is adapted for absorbing heat generated by the light emitting chip 220 and transferring the heat into electric power. The electric power is then outputted to the light emitting chip 220 via an electrode of the substrate 210. In this embodiment, the thermoelectric converter, for example, is made of bismuth telluride, lead telluride or silicon germanium alloy. It is to be noted that the foregoing thermoelectric converter 280 should not be limited as being disposed between the bottom surface 214 of the substrate 210 and the first heat dissipation element 230; it can also be disposed in the substrate 210, wherein the thermoelectric converter 280 in the substrate 210 is in contact with the first heat dissipation element 230.

The heat generated by the light emitting chip 220 can be converted into electric power by the foregoing thermoelectric converter 280. However, it does not mean that the operation temperature of the light emitting device 200e will decrease consequently. Therefore, the first dissipation element 230 can be disposed at a bottom surface 282 of the thermoelectric converter 280 for evacuating the heat generated by the light emitting chip 220 out of the light emitting device 200e.

Referring to FIG. 5b, another light emitting device 200f of a wire bonding type is illustrated. The light emitting device has a thermoelectric converter according to the invention. In order to have the heat generated by the light emitting chip 220 evacuated promptly, the light emitting device 200f further includes a second heat dissipation element 240 disposed between the bottom surface 282 of the thermoelectric converter and the first heat dissipation element 230. In the embodiment, the second heat dissipation element 240, for example, is composed of micro heat pipes or micro channels. The micro heat pipes or the micro channels of the second heat dissipation element 240 can be disposed in the form of parallel lines or radial lines. It is to be noted that the invention is not limited to a light emitting chip 220 of a wire bonding type; it can also be other light emitting chips of a wafer bonding type or flip clip bonding type.

In operation, the heat generated by the light emitting chip 220 of the light emitting device 200f is first conducted to the substrate 210 under the light emitting chip 220. The substrate 210 transfers the absorbed heat to the thermoelectric element 280 under the substrate 210. The thermoelectric converter 280 converts the heat into electric power and outputs the electric power to the light emitting chip 220 via the electrode of the substrate 210.

On the other hand, the absorbed heat is evacuated in sequence by the second heat dissipation element 240 and the first heat dissipation element 230 out of the light emitting device 200f. In the embodiment, the light emitting device 200f can lower the operating temperature of the light emitting chip 220. Therefore, the light emitting efficiency of the light emitting layer 222 can be improved.

In summary, the light emitting device according to the present invention includes a first heat dissipation element and a second heat dissipation element for evacuating the heat generated by the light emitting chip out of the light emitting device. Therefore, the operating temperature of the light emitting chip can be lowered and the light emitting efficiency of the light emitting layer can be improved. Furthermore, the light emitting device further includes a thermoelectric converter disposed at the bottom surface of the substrate. The thermoelectric converter is adapted for converting the heat absorbed from the light emitting chip into electric power and outputting the electric power back to the light emitting chip. Hence, the light emitting device can recycle the power consumed and eliminate the loss of the power evacuated.

It should be noted that specific embodiments of, and examples for, the invention are described herein for illustrative purposes, various equivalent modifications are possible within the scope of the appended claims, as those skilled in the relevant art will recognize that modifications and adaptations of the above-described preferred embodiments of the present invention may be made to meet particular requirements. This disclosure is intended to exemplify the invention without limiting the scope of the appended claims.

## Claims

1. A light emitting device (200a, 200b, 200c, 200d, 200e, 200f) comprising:
a substrate (210) having a top surface (212), on which a plurality of contacts (216) are disposed, and a bottom surface (214);
at least one light emitting chip (220), disposed on the top surface (212)of the substrate (210), being in contact with the contacts (216) of the substrate (210), the light emitting chip (220) comprising a light emitting layer (222), a positive electrode (224) and a negative electrode (226), wherein the light emitting layer (222) can be excited to emit a light by a current applied between the positive electrode (224) and the negative electrode (226); **characterized by:**
a thermoelectric converter (280), disposed at the bottom surface (214) of the substrate (210), and adapted for absorbing heat generated by the light emitting chip (220) and transferring the heat into electric power; and
a first heat dissipating element (230), disposed at a bottom surface (282) of the thermoelectric converter (280).

2. The light emitting device according to claim 1, wherein the substrate (210) is a printed circuit board or a silicon-based substrate.

3. The light emitting device according to claim 1, wherein the first heat dissipation element (230) comprises a metal panel (232), the metal panel (232) having a first surface and a second surface (232a, 232b), the first surface (232a) of the metal panel (232) being in contact with the bottom surface (214) of the substrate (210).

4. The light emitting device according to claim 3, wherein the first heat dissipation element (230) comprises a plurality of fins (234) disposed at the second surface (232b) of the metal panel (232).

5. The light emitting device according to claim 1, further comprising a second heat dissipation element (240) disposed between the bottom surface (214) of the substrate (210) and the first heat dissipation element (230).

6. The light emitting device according to claim 5, wherein the second heat dissipation element (240) is composed of micro heat pipes or micro channels.

7. The light emitting device according to claim 5, wherein the second heat dissipation element (240) is made of copper, aluminum, silver or silicon.

8. The light emitting device according to claim 1 further comprising a plurality of conducting wires (250) and an encapsulation (260), the positive electrode (214) and the negative electrode (226) of the light emitting chip (220) are connected to a contact of the substrate (210) via the conducting wires (250).

9. The light emitting device according to claim 1, further comprising a plurality of bumps (270), by which the positive electrode (224) and the negative electrode (226) of the light emitting chip (220) are connected to the contacts of the substrate (210).

10. The light emitting device according to claim 1, wherein the thermoelectric converter (280) is made of bismuth telluride, lead telluride or silicon germanium alloy.

## Patentansprüche

1. Licht aussendendes Bauelement (200a, 200b, 200c, 200d, 200e, 200f) umfassend:
ein Substrat (210), das eine Oberseite (212), auf der eine Vielzahl von Anschlüssen (216) angeordnet ist, und eine Unterseite (214) aufweist;
mindestens einen Licht aussendenden Chip (220), der auf der Oberseite (212) des Substrats (210) angeordnet und mit den Anschlüssen (216) des Substrats (210) verbunden ist, wobei der Licht aussendende Chip (220) eine Licht aussendende Schicht (222), eine positive Elektrode (224) und eine negative Elektrode (226) umfasst, wobei die Licht aussendende Schicht (222) angeregt werden kann, um Licht von einer elektrischen Stromquelle auszusenden, die zwischen der positiven Elektrode (224) und der negativen Elektrode (226) angeordnet ist; **gekennzeichnet durch:**
einen thermoelektrischen Umwandler (280), der an der Unterseite (214) des Substrats (210) angeordnet ist und sich eignet, die vom Licht aussendenden Chip (220) erzeugte Wärme zu absorbieren und diese in elektrischen Strom umzuwandeln; und
ein erstes Wärme ableitendes Element (230), das an einer Unterseite (282) des thermoelektrischen Umwandlers (280) angeordnet ist.

2. Licht aussendendes Bauelement nach Anspruch 1, wobei das Substrat (210) eine Leiterplatine oder ein auf Silizium basierendes Substrat ist.

3. Licht aussendendes Bauelement nach Anspruch 1, wobei das erste Wärme ableitende Element (230) eine Metallplatte (232) umfasst, wobei die Metallplatte (232) eine erste Oberfläche und eine zweite Oberfläche (232a, 232b) besitzt und wobei die erste Oberfläche (232a) der Metallplatte (232) mit der Unterseite (214) des Substrats (210) verbunden ist.

4. Licht aussendendes Bauelement nach Anspruch 3, wobei das erste Wärme ableitende Element (230) eine Vielzahl von Lamellen (234) aufweist, die an der zweiten Oberfläche (232b) der Metallplatte (232) angeordnet sind.

5. Licht aussendendes Bauelement nach Anspruch 1, ferner umfassend ein zweites Wärme ableitendes Element (240), das zwischen der Unterseite (214) des Substrats (210) und dem ersten Wärme ableitenden Element (230) angeordnet ist.

6. Licht aussendendes Bauelement nach Anspruch 5, wobei das zweite Wärme ableitende Element (240) aus Mikroheizrohren oder Mikrokanälen besteht.

7. Licht aussendendes Bauelement nach Anspruch 5, wobei das zweite Wärme ableitende Element (240) aus Kupfer, Aluminium, Silber oder Silizium hergestellt ist.

8. Licht aussendendes Bauelement nach Anspruch 1, ferner umfassend eine Vielzahl von Leitungsdrähten (250) und eine Kapselung (260), wobei die positive Elektrode (214) und die negative Elektrode (226) des Licht aussendenden Chips (220) mit einem Kontakt des Substrats (210) durch die Leitungsdrähte (250) verbunden sind.

9. Licht aussendendes Bauelement nach Anspruch 1, ferner umfassend eine Vielzahl von Erhebungen (270), mittels derer die positive Elektrode (224) und die negative Elektrode (226) des Licht aussendenden Chips (220) mit den Kontakten des Substrats (210) verbunden sind.

10. Licht aussendendes Bauelement nach Anspruch 1, wobei der thermoelektrische Umwandler (280) aus Bismut-Tellurit, Blei-Tellurit oder einer Silizium-Germanium-Legierung hergestellt ist.

## Revendications

1. Dispositif électroluminescent (200a, 200b, 200c, 200d, 200e, 200f) comprenant :
un substrat (210) présentant une surface supérieure (212) sur laquelle sont disposés une pluralité de contacts (216), et une surface inférieure (214) ;
au moins une puce électroluminescente (220), disposée sur la surface supérieure (212) du substrat (210), en contact avec les contacts (216) du substrat (210), la puce électroluminescente (220) comprenant une couche électroluminescente (222), une électrode positive (224) et une électrode négative (226), où la couche électroluminescente (222) peut être excitée à émettre une lumière par un courant appliqué entre l'électrode positive (224) et l'électrode négative (226) ; **caractérisé par :**
un convertisseur thermoélectrique (280) disposé sur la surface inférieure (214) du substrat (210) et adapté de manière à absorber la chaleur générée par la puce électroluminescente (220) et transformer la chaleur en énergie électrique ; et
un premier élément dissipateur de chaleur (230), disposé sur la surface inférieure (282) du convertisseur thermoélectrique (280).

2. Dispositif électroluminescent selon la revendication 1, dans lequel le substrat (210) est une carte à circuits imprimés ou un substrat à base de silicium.

3. Dispositif électroluminescent selon la revendication 1, dans lequel le premier élément dissipateur de chaleur (230) comprend un panneau métallique (232), ledit panneau métallique (232) présentant une première et une deuxième surface (232a, 232b), la première surface (232a) étant en contact avec la surface inférieure (214) du substrat (210).

4. Dispositif électroluminescent selon la revendication 3, dans lequel le premier élément dissipateur de chaleur (230) comprend une pluralité de nervures (234) disposées sur la deuxième surface (232b) du panneau métallique (232).

5. Dispositif électroluminescent selon la revendication 1, comprenant en outre un deuxième élément dissipateur de chaleur (240) disposé entre la surface inférieure (214) du substrat (210) et le premier élément dissipateur de chaleur (230).

6. Dispositif électroluminescent selon la revendication 5, dans lequel le deuxième élément dissipateur de chaleur (240) se compose de micro-caloducs ou de micro-canaux.

7. Dispositif électroluminescent selon la revendication 5, dans lequel le deuxième élément dissipateur de chaleur (240) est fabriqué en cuivre, aluminium, argent ou silicium.

8. Dispositif électroluminescent selon la revendication 1, comprenant en outre une pluralité de fils conducteurs (250) et une encapsulation (260), l'électrode positive (214) et l'électrode négative (226) de la puce électroluminescente (220) étant raccordées à un contact du substrat (210) par l'intermédiaire des fils conducteurs (250).

9. Dispositif électroluminescent selon la revendication 1, comprenant en outre une pluralité de plots (270) par lesquels l'électrode positive (224) et l'électrode négative (226) de la puce électroluminescente (220) sont raccordées aux contacts du substrat (210).

10. Dispositif électroluminescent selon la revendication 1, dans lequel le convertisseur thermoélectrique (280) est fabriqué en tellurure de bismuth, tellurure de plomb ou alliage silicium-germanium.
